# EUROPÄISCHE PATENTANMELDUNG

(11) **EP 4 089 729 A2**
(43) Veröffentlichungstag der Anmeldung: **16.11.2022**
(21) Anmeldenummer: 22172356.2
(22) Anmeldetag: 09.05.2022
(51) Int. Cl.: H01L 25/07

(54) **HALBLEITERLEISTUNGSMODUL**

(30) Priorität: 10.05.2021 DE 102021204694
(71) Anmelder: Robert Bosch GmbH, 70442 Stuttgart (DE)
(72) Erfinder: Schollbach, Moritz, 72076 Tuebingen (DE); Kaiser, Alexander, 72355 Schoerzingen (DE); Schiele, Christian, 81547 München (DE)

(57) **Zusammenfassung**

Die Erfindung betrifft ein Halbleiterleistungsmodul (1) mit mindestens zwei Halbleiterleistungsschaltern (S1, S2), welche in Längsrichtung nebeneinander parallel zwischen einer ersten Leiterbahn (3H), welche an einem ersten Endbereich mit einem ersten externen Leistungskontakt (LK1) elektrisch kontaktiert ist, und einer räumlich parallel oberhalb der ersten Leiterbahn (3H) verlaufenden zweiten Leiterbahn (5H) angeordnet sind, welche an einem zweiten Endbereich über ein erstes Kontaktstück (KSH) mit einem zweiten externen Leistungskontakt (LK2) elektrisch verbunden ist, wobei jeweils eine erste Anschlussoberfläche der mindestens zwei Halbleiterleistungsschalter (S1, S2) mit der ersten Leiterbahn (3H) und jeweils eine zweite Anschlussoberfläche der mindestens zwei Halbleiterleistungsschalter (S1, S2) mit der zweiten Leiterbahn (5H) elektrisch leitend verbunden ist, so dass sich ein erster Strompfad und ein korrespondierender Stromfluss zwischen dem ersten externen Leistungskontakt (LK1) und dem zweiten externen Leistungskontakt (LK2) auf die mindestens zwei Halbleiterleistungsschalter (S1, S2) aufteilt, wenn die mindestens zwei Halbleiterleistungsschalter (S1, S2) jeweils über eine angelegte Steuerspannung leitend geschaltet sind, wobei einer der mindestens zwei Halbleiterleistungsschalter (S1, S2) näher an dem ersten externen Leistungskontakt (LK1) angeordnet ist und das erste Kontaktstück (KSH) geometrisch zwischen den mindestens zwei Halbleiterleistungsschaltern (S1, S2) aber näher an einem anderen der mindestens zwei Halbleiterleistungsschalter (S1, S2), welcher geometrisch näher am zweiten externen Leistungskontakt (LK2) angeordnet ist, mit der zweiten Leiterbahn (5H) kontaktiert ist, so dass eine erste Leitungsinduktivität (L1) zwischen dem näher am ersten externen Leistungskontakt (LK1) angeordneten Halbleiterleistungsschalter (S1) und dem zweiten externen Leistungskontakt (LK2) größer als eine zweite Leitungsinduktivität (L2) zwischen dem näher am zweiten externen Leistungskontakt (LK2) angeordneten anderen Halbleiterleistungsschalter (S2) und dem zweiten externen Leistungskontakt (LK2) ist.

## Beschreibung

Die Erfindung betrifft ein Halbleiterleistungsmodul mit mindestens zwei Halbleiterleistungsschaltern, welche in Längsrichtung nebeneinander parallel zwischen einer ersten Leiterbahn, welche an einem ersten Endbereich mit einem ersten externen Leistungskontakt elektrisch kontaktiert ist, und einer parallel oberhalb der ersten Leiterbahn verlaufenden zweiten Leiterbahn angeordnet sind, welche an einem zweiten Endbereich über ein erstes Kontaktstück mit einem zweiten externen Leistungskontakt elektrisch verbunden ist. Hierbei ist jeweils eine erste Anschlussoberfläche der mindestens zwei Halbleiterleistungsschalter mit der ersten Leiterbahn und jeweils eine zweite Anschlussoberfläche der mindestens zwei Halbleiterleistungsschalter mit der zweiten Leiterbahn elektrisch leitend verbunden, so dass sich ein erster Strompfad und ein korrespondierender Stromfluss zwischen dem ersten externen Leistungskontakt und dem zweiten externen Leistungskontakt auf die mindestens zwei Halbleiterleistungsschalter aufteilt, wenn die mindestens zwei Halbleiterleistungsschalter jeweils über eine angelegte Steuerspannung leitend geschaltet sind.

Die Leistungselektronik für Hybrid-Elektrofahrzeuge bzw. Elektrofahrzeuge samt zugehöriger Halbleiterleistungsmodule sind zunehmend hohen Bauraumforderungen unterworfen, folglich werden die Halbleiterleistungsmoduls samt elektrischen Zuleitungen kleiner konstruiert. Gleichzeitig steigt die Stromdichte auf Grund gestiegener Leistungsanforderungen an. Kleinere Zuleitungen und höhere Ströme haben allerdings höhere elektrische Verluste (ohmsch als auch frequenzbehaftet) zur Folge. Daher sind bauraumoptimierte Halbleiterleistungsmodul in der Regel mechanisch in Längsrichtung aufgebaut, dies führt jedoch dazu, dass die elektrischen Eigenschafften stark asymmetrisch sind. Daher kann es bei einer Parallelschaltung von Leistungstransistoren dazu kommen, dass ein erster Leistungstransistor den Einschaltvorgang übernimmt und ein zweiter Leistungstransistor den Ausschaltvorgang. Dies kann speziell beim Abschalten eines Kurzschlusses dazu führen, dass die Kurzschlussfähigkeit stark eingeschränkt ist.

Aus der DE 10 2019 206 820 A1 ist ein Halbleiterschaltungsmodul mit einem ersten Leistungstransistor und einem zweiten Leistungstransistor bekannt, welche parallel zwischen einer ersten Kollektorleiterbahn und einer ersten Emitterleiterbahn angeordnet sind, wobei jeweils eine erste Anschlussoberfläche der Leistungstransistoren mit der ersten Kollektorleiterbahn und jeweils eine zweite Anschlussoberfläche der Leistungstransistoren mit der ersten Emitterleiterbahn elektrisch leitend verbunden ist, so dass sich ein zwischen der ersten Kollektorleiterbahn und der ersten Emitterleiterbahn fließender Strom auf die beiden Leistungstransistoren aufteilt, wenn die Leistungstransistoren jeweils über eine angelegte Steuerspannung leitend geschaltet sind. Ein erster externer Leistungskontakt ist direkt an einem ersten Kontaktbereich mit der ersten Kollektorleiterbahn kontaktiert. Ein zweiter externer Leistungskontakt ist über ein erstes Verbindungselement an einem zweiten Kontaktbereich mit der ersten Emitterleiterbahn kontaktiert. Hierbei ist der zweite Kontaktbereich mechanisch unsymmetrisch zwischen den mit der ersten Emitterleiterbahn verbundenen Leistungstransistoren so positioniert, dass sich eine elektrische Symmetrie mit gleichen wirksamen Steuerspannungen an den beiden Leistungstransistoren ergibt.

### Offenbarung der Erfindung

Das Halbleiterleistungsmodul mit den Merkmalen des unabhängigen Patentanspruchs 1 hat den Vorteil, dass über eine spezielle Leitungsführung ein näher am zweiten externen Leistungsanschluss angeordneter Halbleiterleistungsschalter eine Reduzierung seiner Leitungsinduktivität erfährt, so dass sich aufgrund der resultierenden Rückwirkung auf eine Steuerspannung des korrespondierenden Halbleiterleistungsschalters ein schnelleres Schalten und eine Absenkung dieser Steuerspannung und dadurch eine Begrenzung eines Stromflusses durch den Halbleiterleistungsschalter ergibt. Dies wirkt sich insbesondere beim Schalten eines Kurzschlusses vorteilhaft aus, da der resultierende Kurzschlussstrom deutlich begrenzt werden kann. Die effektiv wirksamen Leitungsinduktivitäten der mindestens zwei Halbleiterleistungsschalter werden durch die spezielle Leitungsführung bzw. Verschiebung des Kontaktstücks jedoch nur soweit angepasst, dass sich die Schaltverluste weitestgehend gleich auf die mindestens zwei Halbleiterleistungsschalter verteilen.

Ausführungsformen der vorliegenden Erfindung stellen ein Halbleiterleistungsmodul mit mindestens zwei Halbleiterleistungsschaltern zur Verfügung, welche in Längsrichtung nebeneinander parallel zwischen einer ersten Leiterbahn, welche an einem ersten Endbereich mit einem ersten externen Leistungskontakt elektrisch kontaktiert ist, und einer räumlich parallel oberhalb der ersten Leiterbahn verlaufenden zweiten Leiterbahn angeordnet sind, welche an einem zweiten Endbereich über ein erstes Kontaktstück mit einem zweiten externen Leistungskontakt elektrisch verbunden ist. Hierbei ist jeweils eine erste Anschlussoberfläche der mindestens zwei Halbleiterleistungsschalter mit der ersten Leiterbahn und jeweils eine zweite Anschlussoberfläche der mindestens zwei Halbleiterleistungsschalter ist mit der zweiten Leiterbahn elektrisch leitend verbunden, so dass sich ein erster Strompfad und ein korrespondierender Stromfluss zwischen dem ersten externen Leistungskontakt und dem zweiten externen Leistungskontakt auf die mindestens zwei Halbleiterleistungsschalter aufteilt, wenn die mindestens zwei Halbleiterleistungsschalter jeweils über eine angelegte Steuerspannung leitend geschaltet sind. Zudem ist einer der mindestens zwei Halbleiterleistungsschalter näher an dem ersten externen Leistungskontakt angeordnet, und das erste Kontaktstück ist geometrisch zwischen den mindestens zwei Halbleiterleistungsschaltern aber näher an einem anderen der mindestens zwei Halbleiterleistungsschalter, welcher geometrisch näher am zweiten externen Leistungskontakt angeordnet ist, mit der zweiten Leiterbahn kontaktiert, so dass eine erste Leitungsinduktivität zwischen dem näher am ersten externen Leistungskontakt angeordneten Halbleiterleistungsschalter und dem zweiten externen Leistungskontakt größer als eine zweite Leitungsinduktivität zwischen dem näher am zweiten externen Leistungskontakt angeordneten anderen Halbleiterleistungsschalter und dem zweiten externen Leistungskontakt ist.

Durch die in den abhängigen Ansprüchen aufgeführten Maßnahmen und Weiterbildungen sind vorteilhafte Verbesserungen des im unabhängigen Patentanspruch 1 angegebenen Halbleiterleistungsmoduls möglich.

Besonders vorteilhaft ist, dass mindestens zwei weitere Halbleiterleistungsschalter in Längsrichtung nebeneinander parallel zwischen einer dritten Leiterbahn, welche an einem zweiten Endbereich mit dem zweiten externen Leistungskontakt elektrisch kontaktiert ist, und einer räumlich parallel oberhalb der dritten Leiterbahn verlaufenden vierten Leiterbahn angeordnet sind, welche an einem ersten Endbereich über ein zweites Kontaktstück mit einem dritten externen Leistungskontakt elektrisch verbunden ist. Hierbei ist jeweils eine erste Anschlussoberfläche der mindestens zwei weiteren Halbleiterleistungsschalter mit der dritten Leiterbahn und jeweils eine zweite Anschlussoberfläche der mindestens zwei weiteren Halbleiterleistungsschalter ist mit der vierten Leiterbahn elektrisch leitend verbunden, so dass sich ein zweiter Strompfad und ein korrespondierender Stromfluss zwischen dem zweiten externen Leistungskontakt und dem dritten externen Leistungskontakt fließender Strom auf die mindestens zwei weiteren Halbleiterleistungsschalter aufteilt, wenn die mindestens zwei weiteren Halbleiterleistungsschalter jeweils über eine angelegte Steuerspannung leitend geschaltet sind. Zudem ist einer der mindestens zwei weiteren Halbleiterleistungsschalter näher an dem zweiten externen Leistungskontakt angeordnet, und das zweite Kontaktstück ist geometrisch zwischen den mindestens zwei weiteren Halbleiterleistungsschaltern aber näher an einem anderen der mindestens zwei weiteren Halbleiterleistungsschalter, welcher näher am dritten externen Leistungskontakt angeordnet ist, mit der vierten Leiterbahn kontaktiert, so dass eine dritte Leitungsinduktivität zwischen dem einen näher am zweiten Leistungskontakt angeordneten Halbleiterleistungsschalter und dem dritten externen Leistungskontakt größer als eine vierte Leitungsinduktivität zwischen dem anderen näher am dritten externen Leitungskontakt angeordneten Halbleiterleistungsschalter und dem dritten externen Leistungskontakt ist.

In vorteilhafter Ausgestaltung des Halbleiterleistungsmoduls kann das Halbleiterleistungsmodul als B2-Brücke ausgeführt sein, wobei der erste Strompfad einem High-Side-Strompfad zwischen dem ersten Leistungskontakt und dem zweiten Leistungskontakt entspricht, und der zweite Strompfad einem Low-Side-Strompfad zwischen dem zweiten Leistungskontakt und dem dritten Leistungskontakt entspricht.

In weiterer vorteilhafter Ausgestaltung des Halbleiterleistungsmoduls kann das zweite Kontaktstück über ein Verbindungselement mit dem dritten externen Leistungskontakt verbunden sein. Das Verbindungselement ist vorzugsweise U-förmig ausgeführt, so dass der dritte Leistungskontakt auf einer gemeinsamen Linie mit dem zweiten Leistungskontakt angeordnet ist. Dies ermöglicht eine besonders einfache und kostengünstige Umsetzung der Positionierung des zweiten Kontaktstücks.

In weiterer vorteilhafter Ausgestaltung des Halbleiterleistungsmoduls kann das erste Kontaktstück die zweite Leiterbahn elektrisch mit der dritten Leiterbahn verbinden. Dadurch kann die zweite Leiterbahn elektrisch über das erste Kontaktstück und die dritte Leiterbahn mit dem zweiten externen Leistungskontakt verbunden werden.

In weiterer vorteilhafter Ausgestaltung des Halbleiterleistungsmoduls können der erste externe Leistungskontakt und der dritte externe Leistungskontakt jeweils an einer ersten Stirnseite des Halbleiterleistungsmoduls angeordnet sein, und der zweite externe Leistungskontakt kann an einer der ersten Stirnseite gegenüberliegenden zweiten Stirnseite des Halbleiterleistungsmoduls angeordnet sein. Dies ermöglicht eine einfache Führung der Stromschienen zu Kontaktierung der externen Leistungskontakte des Halbleiterleistungsmoduls.

In weiterer vorteilhafter Ausgestaltung des Halbleiterleistungsmoduls können die erste Leiterbahn und die dritte Leiterbahn parallel nebeneinander in einer gemeinsamen ersten Ebene angeordnet sein, und die zweite Leiterbahn und die vierte Leiterbahn können parallel nebeneinander in einer gemeinsamen zweite Ebene angeordnet sein, welche mit einem räumlichen Abstand parallel und oberhalb zur ersten Ebene verläuft. Dies ermöglicht eine besonders platzsparende Ausführung des Halbleiterleistungsmoduls.

In weiterer vorteilhafter Ausgestaltung des Halbleiterleistungsmoduls können die Halbleiterleistungsschalter beispielsweise als Insulated Gate Bipolar Transistors (IGBTs) oder als Metal-Oxide-Semiconductor Field-Effect Transistors (MOS-FETs) ausgeführt sein.

In weiterer vorteilhafter Ausgestaltung des Halbleiterleistungsmoduls können die Leiterbahnen jeweils als Stromschienen ausgeführt sein. Dies ermöglicht eine kostengünstige Herstellung des Halbleiterleistungsmoduls.

In weiterer vorteilhafter Ausgestaltung des Halbleiterleistungsmoduls kann eine erste Freilaufdiode parallel zu den mindestens zwei Leistungsschaltern zwischen der ersten Leiterbahn und der zweiten Leiterbahn angeordnet sein. Zudem kann eine zweite Freilaufdiode parallel zu den mindestens zwei weiteren Leistungsschaltern zwischen der dritten Leiterbahn und der vierten Leiterbahn angeordnet sein.

Ein Ausführungsbeispiel der Erfindung ist in den Zeichnungen dargestellt und wird in der nachfolgenden Beschreibung näher erläutert. In den Zeichnungen bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Darstellung eines Ausführungsbeispiels eines erfindungsgemäßen Halbleiterleistungsmoduls.
Fig. 2 zeigt ein schematisches elektrisches Schaltbild des erfindungsgemäßen Halbleiterleistungsmoduls aus Fig. 1.
Fig. 3 zeigt ein Kennliniendiagramm des Einschaltverhaltens bei Kurzschluss eines herkömmlichen Halbleiterleistungsmodul.
Fig. 4 zeigt ein Kennliniendiagramm des Einschaltverhaltens bei Kurzschluss des erfindungsgemäßen Halbleiterleistungsmoduls aus Fig. 1 und 2.
Fig. 5 zeigt ein Kennliniendiagramm des Einschaltverhaltens im Normalbetrieb des erfindungsgemäßen Halbleiterleistungsmoduls aus Fig. 1 und 2.
Fig. 6 zeigt ein Kennliniendiagramm des Ausschaltverhaltens im Normalbetrieb des erfindungsgemäßen Halbleiterleistungsmoduls aus Fig. 1 und 2.

### Ausführungsformen der Erfindung

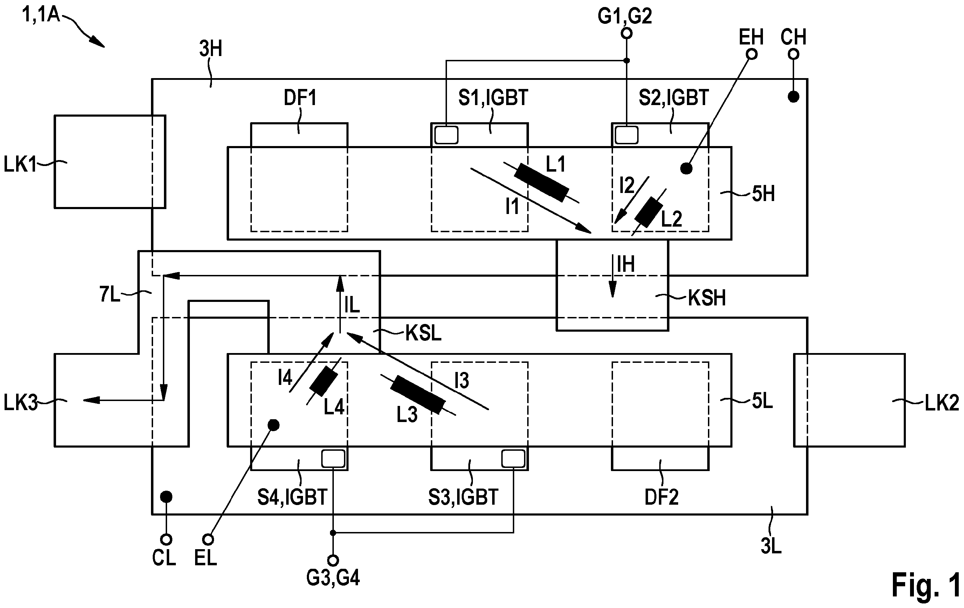

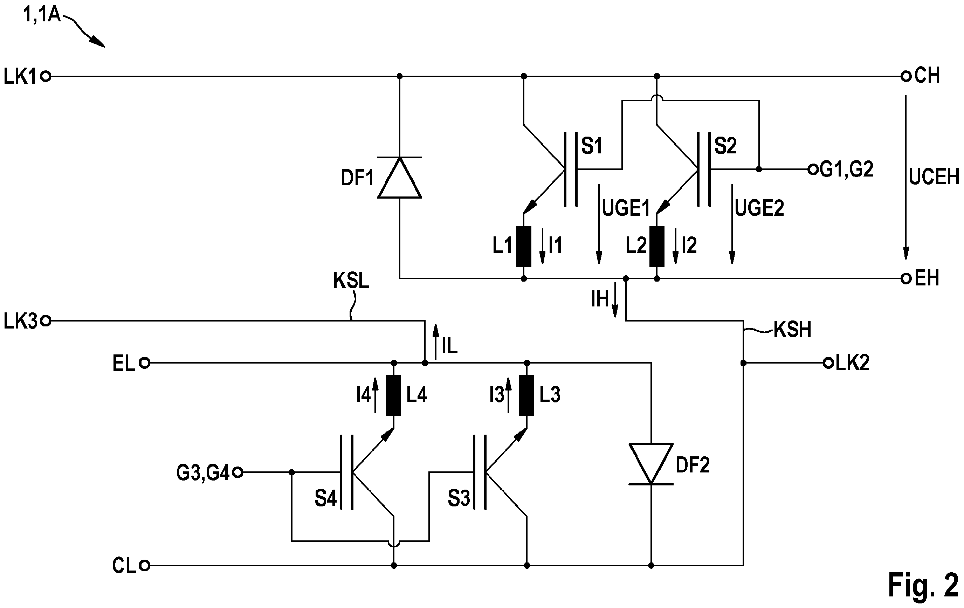

Wie aus Fig. 1 und 2 ersichtlich ist, umfasst das dargestellte Ausführungsbeispiel eines erfindungsgemäßen Halbleiterleistungsmoduls 1 mindestens zwei Halbleiterleistungsschalter S1, S2, welche in Längsrichtung nebeneinander parallel zwischen einer ersten Leiterbahn 3H, welche an einem ersten Endbereich mit einem ersten externen Leistungskontakt LK1 elektrisch kontaktiert ist, und einer räumlich parallel oberhalb der ersten Leiterbahn 3H verlaufenden zweiten Leiterbahn 5H angeordnet sind, welche an einem zweiten Endbereich über ein erstes Kontaktstück KSH mit einem zweiten externen Leistungskontakt LK2 elektrisch verbunden ist. Hierbei ist jeweils eine erste Anschlussoberfläche der mindestens zwei Halbleiterleistungsschalter S1, S2 mit der ersten Leiterbahn 3H und jeweils eine zweite Anschlussoberfläche der mindestens zwei Halbleiterleistungsschalter S1, S2 ist mit der zweiten Leiterbahn 5H elektrisch leitend verbunden ist, so dass sich ein erster Strompfad und ein korrespondierender Stromfluss zwischen dem ersten externen Leistungskontakt LK1 und dem zweiten externen Leistungskontakt LK2 auf die mindestens zwei Halbleiterleistungsschalter S1, S2 aufteilt, wenn die mindestens zwei Halbleiterleistungsschalter S1, S2 jeweils über eine angelegte Steuerspannung leitend geschaltet sind. Zudem ist einer der mindestens zwei Halbleiterleistungsschalter S1, S2 näher an dem ersten externen Leistungskontakt LK1 angeordnet, und das erste Kontaktstück KSH ist geometrisch zwischen den mindestens zwei Halbleiterleistungsschaltern S1, S2 aber näher an einem anderen der mindestens zwei Halbleiterleistungsschalter S1, S2, welcher geometrisch näher am zweiten externen Leistungskontakt LK2 angeordnet ist, mit der zweiten Leiterbahn 5H kontaktiert, so dass eine erste Leitungsinduktivität L1 zwischen dem näher am ersten externen Leistungskontakt LK1 angeordneten Halbleiterleistungsschalter S1 und dem zweiten externen Leistungskontakt LK2 größer als eine zweite Leitungsinduktivität L2 zwischen dem näher am zweiten externen Leistungskontakt LK2 angeordneten anderen Halbleiterleistungsschalter S2 und dem zweiten externen Leistungskontakt LK2 ist.

Wie aus Fig. 1 und 2 weiter ersichtlich ist, sind mindestens zwei weitere Halbleiterleistungsschalter S3, S4 in Längsrichtung nebeneinander parallel zwischen einer dritten Leiterbahn 3L, welche an einem zweiten Endbereich mit dem zweiten externen Leistungskontakt LK2 elektrisch kontaktiert ist, und einer räumlich parallel oberhalb der dritten Leiterbahn 3L verlaufenden vierten Leiterbahn 5L angeordnet, welche an einem ersten Endbereich über ein zweites Kontaktstück KSL mit einem dritten externen Leistungskontakt LK3 elektrisch verbunden ist. Hierbei ist jeweils eine erste Anschlussoberfläche der mindestens zwei weiteren Halbleiterleistungsschalter S3, S4 mit der dritten Leiterbahn 3L und jeweils eine zweite Anschlussoberfläche der mindestens zwei weiteren Halbleiterleistungsschalter S3, S4 ist mit der vierten Leiterbahn 5L elektrisch leitend verbunden, so dass sich ein zweiter Strompfad und ein korrespondierender Stromfluss zwischen dem zweiten externen Leistungskontakt LK2 und dem dritten externen Leistungskontakt LK3 fließender Strom auf die mindestens zwei weiteren Halbleiterleistungsschalter S3, S4 aufteilt, wenn die mindestens zwei weiteren Halbleiterleistungsschalter S3, S4 jeweils über eine angelegte Steuerspannung leitend geschaltet sind. Zudem ist einer der mindestens zwei weiteren Halbleiterleistungsschalter S3, S4 näher an dem zweiten externen Leistungskontakt LK2 angeordnet, und das zweite Kontaktstück KSL ist geometrisch zwischen den mindestens zwei weiteren Halbleiterleistungsschaltern S3, S4 aber näher an einem anderen der mindestens zwei weiteren Halbleiterleistungsschalter S3, S4, welcher näher am dritten externen Leistungskontakt LK3 angeordnet ist, mit der vierten Leiterbahn 5H kontaktiert, so dass eine dritte Leitungsinduktivität L3 zwischen dem einen näher am zweiten Leistungskontakt LK2 angeordneten Halbleiterleistungsschalter S3 und dem dritten externen Leistungskontakt LK3 größer als eine vierte Leitungsinduktivität L4 zwischen dem anderen näher am dritten externen Leitungskontakt LK3 angeordneten Halbleiterleistungsschalter S4 und dem dritten externen Leistungskontakt LK3 ist.

Im dargestellten Ausführungsbeispiel ist das Halbleiterleistungsmodul 1 als B2-Brücke 1A ausgeführt, welche vier Halbleiterleistungsschalter S1, S2, S3, S4 umfasst. Daher liegt am ersten externen Leistungskontakt LK1 ein erstes Gleichspannungspotential und am dritten externen Leistungskontakt LK3 ein zweites Gleichspannungspotential am. Am zweiten externen Leistungskontakt LK2 liegt ein Wechselspannungspotential an. Im dargestellten Ausführungsbeispiel des Halbleiterleistungsmoduls 1 bildet der erste Strompfad, welcher einen ersten Halbleiterleistungsschalter S1 und einen parallelgeschalteten zweiten Halbleiterleistungsschalter S2 umfasst, einen High-Side-Pfad zwischen dem ersten externen Leistungskontakt LK1 und dem zweiten externen Leistungskontakt LK2 aus. Hierbei teilt sich der Strom IH im High-Side-Pfad in die beiden Teilströme I1 und I2 auf. Der zweite Strompfad, welcher einen dritten Halbleiterleistungsschalter S3 und einen parallelgeschalteten vierten Halbleiterleistungsschalter S4 umfasst, bildet einen Low-Side-Pfad zwischen dem zwei externen Leistungskontakt LK2 und dem dritten externen Leistungskontakt LK3 aus. Hierbei teilt sich der Strom IL im Low-Side-Pfad in die beiden Teilströme I3 und I4 auf. Im dargestellten Ausführungsbeispiel sind die Halbleiterleistungsschalter S1, S2, S3, S4 jeweils als IGBT (IGBT: Insulated Gate Bipolar Transistor, Bipolartransistoren mit isoliertem Gate) ausgeführt. Selbstverständlich können die Halbleiterleistungsschalter S1, S2, S3, S4 alternativ auch als anderes Halbleiterbauteil, wie beispielsweise als MOSFET (MOSFET: Metal-Oxide-Semiconductor Field-Effect Transistor, Metall-Oxid-Halbleiter-Feldeffekttransistor), ausgeführt werden. Zudem ist eine erste Freilaufdiode DF1 im High -Side-Pfad parallel zum ersten Halbleiterleistungsschalter S1 und zum zweiten Halbleiterleistungsschalter S2 zwischen der ersten Leiterbahn 3H und der zweiten Leiterbahn 5H angeordnet. Eine zweite Freilaufdiode DF2 ist im Low-Side-Pfad parallel zum dritten Halbleiterleistungsschalter S3 und zum vierten Halbleiterleistungsschalter S4 zwischen der dritten Leiterbahn 3L und der vierten Leiterbahn 5H angeordnet.

Die Leiterbahnen 3H, 3L, 5H, 5L sind im dargestellten Ausführungsbeispiel jeweils als Stromschienen ausgeführt. Hierbei sind die erste Leiterbahn 3H und die dritte Leiterbahn 3L parallel nebeneinander in einer gemeinsamen ersten Ebene angeordnet. Die zweite Leiterbahn 5H und die vierte Leiterbahn 5L sind parallel nebeneinander in einer gemeinsamen zweiten Ebene angeordnet, welche mit einem räumlichen Abstand parallel und oberhalb zur ersten Ebene verläuft.

Wie aus Fig. 1 weiter ersichtlich ist, der erste externe Leistungskontakt LK1 und der dritte externe Leistungskontakt LK3 jeweils an einer ersten Stirnseite des Halbleiterleistungsmoduls S1 angeordnet. Das bedeutet, dass der erste externe Leistungskontakt LK1 an einer ersten Stirnseite der ersten Leiterbahn 3H mit dieser kontaktiert ist. Der dritte externe Leistungskontakt LK3 ist über ein Verbindungselement 7L und das zweite Kontaktstück KSL mit der vierten Leiterbahn 5L verbunden. Der zweite externe Leistungskontakt LK2 ist an einer der ersten Stirnseite gegenüberliegenden zweiten Stirnseite des Halbleiterleistungsmoduls 1 angeordnet. Das bedeutet, dass der zweite externe Leistungskontakt LK2 an einer zweiten Stirnseite der dritten Leiterbahn 3L mit dieser kontaktiert ist. Zudem verbindet das erste Kontaktstück KSH die zweite Leiterbahn 5H elektrisch mit der dritten Leiterbahn 2L. Wie aus Fig. 1 weiter ersichtlich ist, ist das Verbindungselement 7 U-förmig ausgeführt, so dass der dritte Leistungskontakt LK3 auf einer gemeinsamen Linie mit dem zweiten Leistungskontakt LK2 angeordnet ist.

Wie aus Fig. 1 und 2 weiter ersichtlich ist, weist das dargestellte Halbleiterleistungsmodul 1 noch weiter externe Kontakte auf. Hierbei ist ein erster externe Kollektorkontakt CH über einen Bonddraht mit der ersten Leiterbahn 3H bzw. mit Kollektoranschlüssen der als IGBT ausgeführten Halbleiterleistungsschalter S1, S2 des High-Side-Pfads des Halbleiterleistungsmoduls 1 verbunden. Ein erster externer Emitterkontakt EH ist über einen Bonddraht mit der zweiten Leiterbahn 5H bzw. mit Emitteranschlüssen der als IGBT ausgeführten Halbleiterleistungsschalter S1, S2 des High-Side-Pfads des Halbleiterleistungsmoduls 1 verbunden. Ein erster externer Gatekontakt G1 ist über einen Bonddraht mit einem Gateanschluss des ersten Halbleiterleistungsschalters S1 des High-Side-Pfads des Halbleiterleistungsmoduls 1 verbunden. Ein zweiter externe Gatekontakt G2 ist über einen Bonddraht mit einem Gateanschluss des zweiten Halbleiterleistungsschalters S2 des High-Side-Pfads des Halbleiterleistungsmoduls 1 verbunden. Hierbei sind die beiden externen Gatekontakte G1, G2 miteinander verbunden und werden von demselben externen Steuersignal beaufschlagt. Ein zweiter externer Kollektorkontakt CL ist über einen Bonddraht mit der dritten Leiterbahn 3L bzw. mit Kollektoranschlüssen der als IGBT ausgeführten Halbleiterleistungsschalter S3, S4 des Low-Side-Pfads des Halbleiterleistungsmoduls 1 verbunden. Ein zweiter externer Emitterkontakt EL ist über einen Bonddraht mit der vierten Leiterbahn 5L bzw. mit Emitteranschlüssen der als IGBT ausgeführten Halbleiterleistungsschalter S3, S4 des High-Side-Pfads des Halbleiterleistungsmoduls 1 verbunden. Ein dritter externer Gatekontakt G3 ist über einen Bonddraht mit einem Gateanschluss des dritten Halbleiterleistungsschalters S3 des Low-Side-Pfads des Halbleiterleistungsmoduls 1 verbunden. Ein vierter externer Gatekontakt G4 ist über einen Bonddraht mit einem Gateanschluss des vierten Halbleiterleistungsschalter S4 des Low-Side-Pfads des Halbleiterleistungsmoduls 1 verbunden. Hierbei sind die beiden externen Gatekontakte G3, G4 miteinander verbunden und werden von demselben externen Steuersignal beaufschlagt.

Wie aus Fig. 2 weiter ersichtlich ist, wird eine erste Gatespannung UGE1 zwischen dem ersten externen Emitterkontakt EH und einem Steueranschluss des ersten Halbleiterleistungsschalters S1 gemessen. Eine zweite Gatespannung UGE2 wird zwischen einem Steueranschluss des zweiten Halbleiterleistungsschalters S2 und dem ersten externen Emitterkontakt EH gemessen. Eine Kollektorspannung UCEH wird zwischen dem ersten externen Kollektorkontakt CH und dem ersten externen Emitterkontakt EH gemessen.

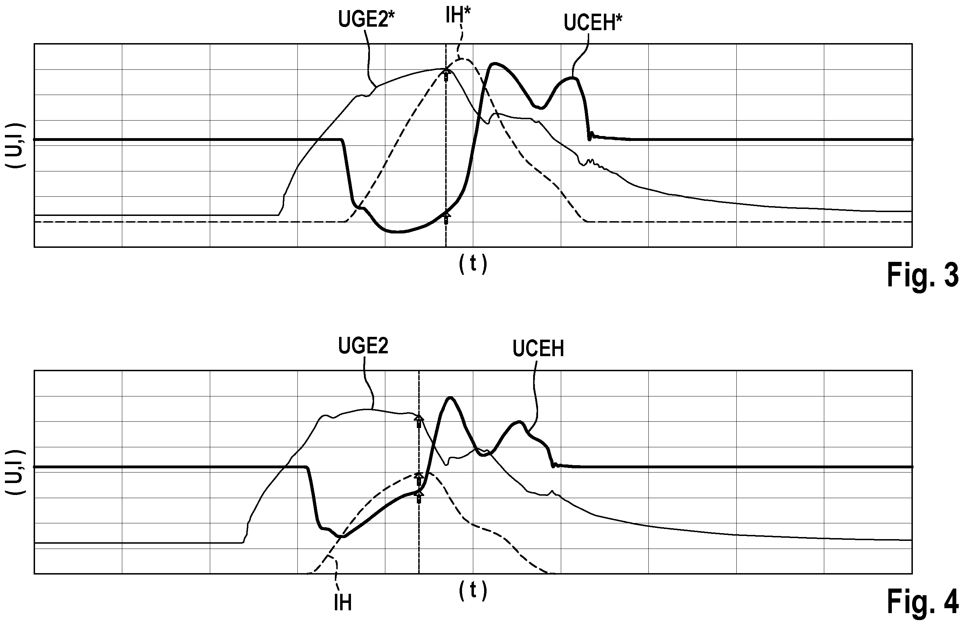

Das in Fig. 3 dargestellte Kennliniendiagramm zeigt verschiedene Spannungskennlinien UGE2*, UCEH* und eine Stromkennlinie IH* im High-Side-Pfad eines nicht dargestellten Halbleiterleistungsmoduls bei einem Kurzschluss im Low-Side-Pfad. Bei dem nicht dargestellten Halbleiterleistungsmodul ist das erste Kontaktstück KSH geometrisch mittig zwischen dem ersten Halbleiterleistungsschalter S1 und dem zweiten Halbleiterleistungsschalter S2 angeordnet. Das zweite Kontaktstück KSL ist geometrisch mittig zwischen dem dritten Halbleiterleistungsschalter S3 und dem vierten Halbleiterleistungsschalter S4 angeordnet. In dem in Fig. 3 dargestellten Kennliniendiagramm bezeichnet IH* einen im High-Side-Pfad des nicht dargestellten Halbleiterleistungsmoduls fließenden Strom. UGE2* bezeichnet eine zwischen einem Steueranschluss des zweiten Halbleiterleistungsschalters S2 und dem ersten externen Emitterkontakt EH des nicht dargestellten Halbleiterleistungsmoduls gemessene zweite Gatespannung. UCEH* bezeichnet eine zwischen dem ersten externen Kollektorkontakt CH und dem ersten externen Emitterkontakt EH des nicht dargestellten Halbleiterleistungsmoduls gemessene Kollektorspannung.

Das in Fig. 4 dargestellte Kennliniendiagramm zeigt verschiedene Spannungskennlinien UGE2, UCEH und eine Stromkennlinie IH im High-Side-Pfad des erfindungsgemäßen Halbleiterleistungsmoduls 1 bei einem Kurzschluss im Low-Side-Pfad. In dem in Fig. 4 dargestellten Kennliniendiagramm bezeichnet IH den im High-Side-Pfad des erfindungsgemäßen Halbleiterleistungsmoduls 1 fließenden Strom. UGE2 bezeichnet eine zwischen einem Steueranschluss des zweiten Halbleiterleistungsschalters S2 und dem ersten externen Emitterkontakt EH des erfindungsgemäßen Halbleiterleistungsmoduls 1 gemessene zweite Gatespannung. UCEH bezeichnet eine zwischen dem ersten externen Kollektorkontakt CH und dem ersten externen Emitterkontakt EH des erfindungsgemäßen Halbleiterleistungsmoduls gemessene Kollektorspannung.

Wie durch einen Vergleich der beiden Kennliniendiagramme aus Fig. 3 und Fig. 4 ersichtlich ist, kann durch Ausführungsformen des erfindungsgemäßen Halbleiterleistungsmoduls 1 eine Absenkung der zweiten Gatespannung UGE2 am zweiten Halbleiterleistungsschalter S2 des High-Side-Pfads des erfindungsgemäßen Halbleiterleistungsmoduls 1 erzielt werden. Die Absenkung der zweiten Gatespannung UGE2 resultiert auf der Absenkung der Emitterspannung am zweiten Halbleiterleistungsschalter S2, welche auf der starken Stromänderung des resultierenden Kurzschlussstroms in Kombination mit der veränderten Leitungsinduktivität L2 über das Wirkprinzip (-u=L+di/dt) beruht. Dadurch kann der Strom IH im High-Side-Pfad des erfindungsgemäßen Halbleiterleistungsmoduls 1 im Kurzschlussfall im Vergleich zu dem Strom IH* im High-Side-Pfad des nicht dargestellten Halbleiterleistungsmoduls deutlich reduziert werden.

Die Spannungen und Ströme der Halbleiterleistungsschalter S3, S4 im Low-Side-Pfad des erfindungsgemäßen Halbleiterleistungsmoduls 1 verhalten sich bei einem Kurzschluss im High-Side-Pfad analog.

Die veränderten Leitungsinduktivitäten L1, L2, L3, L4 haben natürlich auch Einfluss auf die Schaltvorgänge im Normalbetrieb. Hier kann jedoch darauf geachtet werden, dass sich die Verluste beim Einschalten durch die Umkehr der Stromrichtung beim Ausschalten kompensieren lassen.

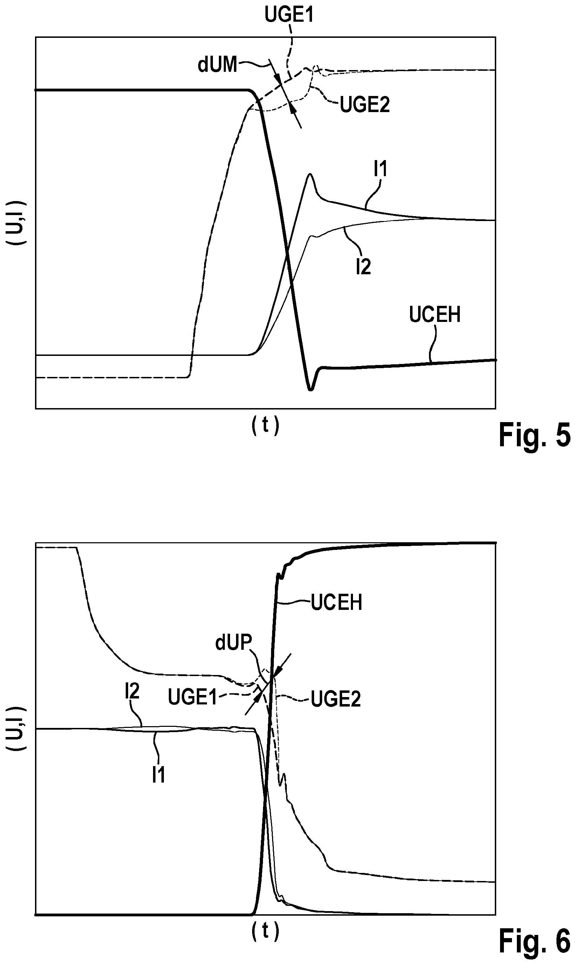

Das in Fig. 5 dargestellte Kennliniendiagramm zeigt verschiedene Spannungskennlinien UGE1, UGE2, UCEH und zwei Stromkennlinien I1, I2 im High-Side-Pfad des erfindungsgemäßen Halbleiterleistungsmoduls 1 bei einem Einschaltvorgang im Normalbetrieb. Das in Fig. 6 dargestellte Kennliniendiagramm zeigt verschiedene Spannungskennlinien UGE1, UGE2, UCEH und zwei Stromkennlinien I1, I2 im High-Side-Pfad des erfindungsgemäßen Halbleiterleistungsmoduls 1 bei einem Ausschaltvorgang im Normalbetrieb. In den dargestellten Kennliniendiagrammen bezeichnet I1 den durch den ersten Halbleiterleistungsschalter S1 fließenden Strom. I2 bezeichnet den durch den zweiten Halbleiterleistungsschalter S2 fließenden Strom. UGE1 bezeichnet eine zwischen einem Steueranschluss des ersten Halbleiterleistungsschalters S1 und dem ersten externen Emitterkontakt EH des erfindungsgemäßen Halbleiterleistungsmoduls 1 gemessene erste Gatespannung. UGE2 bezeichnet eine zwischen einem Steueranschluss des zweiten Halbleiterleistungsschalters S2 und dem ersten externen Emitterkontakt EH des erfindungsgemäßen Halbleiterleistungsmoduls 1 gemessene zweite Gatespannung. UCEH bezeichnet eine zwischen dem ersten externen Kollektorkontakt CH und dem ersten externen Emitterkontakt EH des erfindungsgemäßen Halbleiterleistungsmoduls gemessene Kollektorspannung. dUM bezeichnet eine Absenkung der zweiten Gatespannung UGE2 im Vergleich zur ersten Gatespannung während des Einschaltvorgangs. dUP bezeichnet eine Anhebung der zweiten Gatespannung im Vergleich zur ersten Gatespannung während des Ausschaltvorgangs.

Die Spannungen und Ströme der Halbleiterleistungsschalter S3, S4 im Low-Side-Pfad des erfindungsgemäßen Halbleiterleistungsmoduls 1 verhalten sich im Normalbetrieb analog.

## Patentansprüche

1. Halbleiterleistungsmodul (1) mit mindestens zwei Halbleiterleistungsschaltern (S1, S2), welche in Längsrichtung nebeneinander parallel zwischen einer ersten Leiterbahn (3H), welche an einem ersten Endbereich mit einem ersten externen Leistungskontakt (LK1) elektrisch kontaktiert ist, und einer räumlich parallel oberhalb der ersten Leiterbahn (3H) verlaufenden zweiten Leiterbahn (5H) angeordnet sind, welche an einem zweiten Endbereich über ein erstes Kontaktstück (KSH) mit einem zweiten externen Leistungskontakt (LK2) elektrisch verbunden ist, wobei jeweils eine erste Anschlussoberfläche der mindestens zwei Halbleiterleistungsschalter (S1, S2) mit der ersten Leiterbahn (3H) und jeweils eine zweite Anschlussoberfläche der mindestens zwei Halbleiterleistungsschalter (S1, S2) mit der zweiten Leiterbahn (5H) elektrisch leitend verbunden ist, so dass sich ein erster Strompfad und ein korrespondierender Stromfluss zwischen dem ersten externen Leistungskontakt (LK1) und dem zweiten externen Leistungskontakt (LK2) auf die mindestens zwei Halbleiterleistungsschalter (S1, S2) aufteilt, wenn die mindestens zwei Halbleiterleistungsschalter (S1, S2) jeweils über eine angelegte Steuerspannung leitend geschaltet sind, wobei einer der mindestens zwei Halbleiterleistungsschalter (S1, S2) näher an dem ersten externen Leistungskontakt (LK1) angeordnet ist und das erste Kontaktstück (KSH) geometrisch zwischen den mindestens zwei Halbleiterleistungsschaltern (S1, S2) aber näher an einem anderen der mindestens zwei Halbleiterleistungsschalter (S1, S2), welcher geometrisch näher am zweiten externen Leistungskontakt (LK2) angeordnet ist, mit der zweiten Leiterbahn (5H) kontaktiert ist, so dass eine erste Leitungsinduktivität (L1) zwischen dem näher am ersten externen Leistungskontakt (LK1) angeordneten Halbleiterleistungsschalter (S1) und dem zweiten externen Leistungskontakt (LK2) größer als eine zweite Leitungsinduktivität (L2) zwischen dem näher am zweiten externen Leistungskontakt (LK2) angeordneten anderen Halbleiterleistungsschalter (S2) und dem zweiten externen Leistungskontakt (LK2) ist.

2. Halbleiterleistungsmodul (1) nach Anspruch 1, **dadurch gekennzeichnet, dass** mindestens zwei weitere Halbleiterleistungsschalter (S3, S4) in Längsrichtung nebeneinander parallel zwischen einer dritten Leiterbahn (3L), welche an einem zweiten Endbereich mit dem zweiten externen Leistungskontakt (LK2) elektrisch kontaktiert ist, und einer räumlich parallel oberhalb der dritten Leiterbahn (3L) verlaufenden vierten Leiterbahn (5L) angeordnet sind, welche an einem ersten Endbereich über ein zweites Kontaktstück (KSL) mit einem dritten externen Leistungskontakt (LK3) elektrisch verbunden ist, wobei jeweils eine erste Anschlussoberfläche der mindestens zwei weiteren Halbleiterleistungsschalter (S3, S4) mit der dritten Leiterbahn (3L) und jeweils eine zweite Anschlussoberfläche der mindestens zwei weiteren Halbleiterleistungsschalter (S3, S4) mit der vierten Leiterbahn (5L) elektrisch leitend verbunden ist, so dass sich ein zweiter Strompfad und ein korrespondierender Stromfluss zwischen dem zweiten externen Leistungskontakt (LK2) und dem dritten externen Leistungskontakt (LK3) fließender Strom auf die mindestens zwei weiteren Halbleiterleistungsschalter (S3, S4) aufteilt, wenn die mindestens zwei weiteren Halbleiterleistungsschalter (S3, S4) jeweils über eine angelegte Steuerspannung leitend geschaltet sind, wobei einer der mindestens zwei weiteren Halbleiterleistungsschalter (S3, S4) näher an dem zweiten externen Leistungskontakt (LK2) angeordnet ist und das zweite Kontaktstück (KSL) geometrisch zwischen den mindestens zwei weiteren Halbleiterleistungsschaltern (S3, S4) aber näher an einem anderen der mindestens zwei weiteren Halbleiterleistungsschalter (S3, S4), welcher näher am dritten externen Leistungskontakt (LK3) angeordnet ist, mit der vierten Leiterbahn (5H) kontaktiert ist, so dass eine dritte Leitungsinduktivität (L3) zwischen dem einen näher am zweiten Leistungskontakt (LK2) angeordneten Halbleiterleistungsschalter (S3) und dem dritten externen Leistungskontakt (LK3) größer als eine vierte Leitungsinduktivität (L4) zwischen dem anderen näher am dritten externen Leitungskontakt (LK3) angeordneten Halbleiterleistungsschalter (S4) und dem dritten externen Leistungskontakt (LK3) ist.

3. Halbleiterleistungsmodul (1) nach Anspruch 1 und 2, **dadurch gekennzeichnet, dass** das Halbleiterleistungsmodul (1) als B2-Brücke (1A) ausgeführt ist, wobei der erste Strompfad einem High-Side-Strompfad zwischen dem ersten Leistungskontakt (LK1) und dem zweiten Leistungskontakt (LK2) entspricht, und der zweite Strompfad einem Low-Side-Strompfad zwischen dem zweiten Leistungskontakt (LK2) und dem dritten Leistungskontakt (LK2) entspricht.

4. Halbleiterleistungsmodul (1) nach Anspruch 2 oder 3, **dadurch gekennzeichnet, dass** das das zweite Kontaktstück (KSL) über ein Verbindungselement (7L) mit dem dritten externen Leistungskontakt (LK3) verbunden ist.

5. Halbleiterleistungsmodul (1) nach Anspruch 4, **dadurch gekennzeichnet, dass** das Verbindungselement (7) U-förmig ausgeführt ist, so dass der dritte Leistungskontakt (LK3) auf einer gemeinsamen Linie mit dem zweiten Leistungskontakt (LK2) angeordnet ist.

6. Halbleiterleistungsmodul (1) nach einem der Ansprüche 2 bis 5, **dadurch gekennzeichnet, dass** das erste Kontaktstück (KSH) die zweite Leiterbahn (5H) elektrisch mit der dritten Leiterbahn (2L) verbindet.

7. Halbleiterleistungsmodul (1) nach einem der Ansprüche 2 bis 6, **dadurch gekennzeichnet, dass** der erste externe Leistungskontakt (LK1) und der dritte externe Leistungskontakt (LK3) jeweils an einer ersten Stirnseite des Halbleiterleistungsmoduls (S1) angeordnet sind, und der zweite externe Leistungskontakt (LK2) an einer der ersten Stirnseite gegenüberliegenden zweiten Stirnseite des Halbleiterleistungsmoduls (1) angeordnet ist.

8. Halbleiterleistungsmodul (1) nach einem der Ansprüche 2 bis 7, **dadurch gekennzeichnet, dass** die erste Leiterbahn (3H) und die dritte Leiterbahn (3L) parallel nebeneinander in einer gemeinsamen ersten Ebene angeordnet sind, und die zweite Leiterbahn (5H) und die vierte Leiterbahn (5L) parallel nebeneinander in einer gemeinsamen zweite Ebene angeordnet sind, welche mit einem räumlichen Abstand parallel und oberhalb zur ersten Ebene verläuft.

9. Halbleiterleistungsmodul (1) nach einem der Ansprüche 1 bis 8, **dadurch gekennzeichnet, dass** die Halbleiterleistungsschalter (S1, S2, S3, S4) als Insulated Gate Bipolar Transistoren (IGBT) oder als Metal-Oxide-Semiconductor Field-Effect Transistor (MOSFET) ausgeführt sind.

10. Halbleiterleistungsmodul (1) nach einem der Ansprüche 1 bis 9, **dadurch gekennzeichnet, dass** die Leiterbahnen (3H, 3L, 5H, 5L) jeweils als Stromschienen ausgeführt sind.

11. Halbleiterleistungsmodul (1) nach einem der Ansprüche 1 bis 10, **dadurch gekennzeichnet, dass** eine erste Freilaufdiode (DF1) parallel zu den mindestens zwei Leistungsschaltern (S1, S2) zwischen der ersten Leiterbahn (3H) und der zweiten Leiterbahn (5H) angeordnet ist.

12. Halbleiterleistungsmodul (1) nach einem der Ansprüche 2 bis 11, **dadurch gekennzeichnet, dass** eine zweite Freilaufdiode (DF2) parallel zu den mindestens zwei weiteren Leistungsschaltern (S3, S4) zwischen der dritten Leiterbahn (3L) und der vierten Leiterbahn (5L) angeordnet ist.
